# FASCICULE DE BREVET EUROPEEN

(11) **EP 3 631 044 B1**
(45) Date de publication et mention de la délivrance du brevet: **26.01.2022**
(21) Numéro de dépôt: 18729590.2
(22) Date de dépôt: 22.05.2018
(51) Int. Cl.: C23F 1/00, C23F 1/12, C23C 14/18, C23C 14/58, H01L 31/0224, H01L 31/18, H01L 33/42

(54) **PROCEDE DE PREPARATION D'UNE MEMBRANE CONDUCTRICE, TRANSPARENTE ET FLEXIBLE**
VERFAHREN ZUR HERSTELLUNG EINER LEITFÄHIGEN, TRANSPARENTEN UND FLEXIBLEN MEMBRAN
METHOD FOR PREPARING A CONDUCTIVE, TRANSPARENT AND FLEXIBLE MEMBRANE

(30) Priorité: 24.05.2017 FR 1754647
(43) Date de publication de la demande: 08.04.2020
(73) Titulaire: Centre National de la Recherche Scientifique, 75016 Paris (FR); Universite de Nantes, 44000 Nantes (FR)
(72) Inventeur: EL MEL, Abdel-Aziz, 44300 Nantes (FR); TESSIER, Pierre-Yves, 44300 Nantes (FR); CHAUVIN, Adrien, 49420 Pouance (FR)
(74) Mandataire: Lavoix
(86) Numéro de dépôt international: PCT/EP2018/063308
(87) Numéro de publication internationale: WO 2018/215413

(56) Documents cités:
- WO-A1-2012/102714
- WO-A1-2012/102715
- US-A1- 2014 268 490
- XUELING QUAN ET AL: "Development of nanoporous gold electrodes for electrochemical applications", MICROELECTRONIC ENGINEERING, vol. 88, no. 8, 5 janvier 2011 (2011-01-05), pages 2379-2382, XP028098130, ISSN: 0167-9317, DOI: 10.1016/J.MEE.2010.12.121 [extrait le 2011-01-05]
- HU X ET AL: "Electrochemiluminescence of CdTe quantum dots as labels at nanoporous gold leaf electrodes for ultrasensitive DNA analysis", TALANTA, ELSEVIER, AMSTERDAM, NL, vol. 80, no. 5, 15 mars 2010 (2010-03-15), pages 1737-1743, XP026892687, ISSN: 0039-9140, DOI: 10.1016/J.TALANTA.2009.10.015 [extrait le 2009-11-11]
- OKMAN O ET AL: "Fabrication of crack-free nanoporous gold blanket thin films by potentiostatic dealloying", SCRIPTA MATERIALIA, ELSEVIER, AMSTERDAM, NL, vol. 63, no. 10, 1 novembre 2010 (2010-11-01), pages 1005-1008, XP027259975, ISSN: 1359-6462 [extrait le 2010-07-27]

## Description

### 1. Domaines

L'invention se rapporte aux domaines techniques des électrodes transparentes et conductrices.

Plus précisément, l'invention concerne une membrane composée d'un réseau percolé de domaines nanomaillés métalliques apte à constituer une telle électrode transparente, et un procédé de préparation d'une telle membrane. L'ensemble du réseau percolée des domaines nanomaillés est désigné par le terme de membrane nanomaillée.

### 2. Art antérieur

Le marché des électrodes conductrices transparentes est en plein essor avec une croissance alimentée principalement par les tablettes tactiles, les téléphones mobiles intelligents, les écrans plats, les ultraportables, les cellules solaires ainsi que les diodes électroluminescentes organiques. Le marché global des électrodes transparentes devrait être de 5.1 Milliards de dollars américains en 2020. En terme de taille, les écrans flexibles, les segments d'affichage sont réputés représenter le marché le plus important. Les tendances du marché vont vers le développement de systèmes robustes de grande taille, à faible consommation d'énergie. La flexibilité ainsi que le faible coût de fabrication sont donc des facteurs clés dans le processus de fabrication d'électrodes conductrices.

Il est connu de faire entrer de l'oxyde d'indium-étain (ITO) en couches minces dans la composition d'électrodes conductrices transparentes. L'ITO présente cependant trois inconvénients majeurs. En premier lieu, sa disponibilité est limitée dans le temps, compte tenu de l'épuisement rapide, à l'échelle mondiale, des réserves d'indium. Par répercussion, le coût relatif de l'ITO est élevé, en comparaison d'autres matériaux, ce qui peut représenter un inconvénient prohibitif dans la perspective d'une production à grande échelle. Le second inconvénient de l'ITO est sa stabilité mécanique. Les couches d'ITO sont en effet fragiles et ne peuvent pas subir de fortes déformations sans qu'une dégradation significative de leurs propriétés électriques ne soit constatée. Leurs performances sont donc réduites dans le cadre d'une utilisation dans le domaine de l'électronique souple et/ou flexible. Enfin, la synthèse de couches d'ITO de qualité satisfaisante nécessite l'utilisation de procédés mis en œuvre à de hautes températures, qui sont incompatibles avec les films polymère utilisés dans l'électronique souple.

Les technologies connues de substitution de l'ITO comprennent les couches minces d'oxydes de Zinc dopées en Aluminium (ZnO:AI), les nanofils d'argent, les grilles métalliques, les nanotubes de carbone, le graphène, les films métalliques, ainsi que les membranes métalliques nanoporeuses. Les couches ITO et ZnO:Al ont pour inconvénient commun de présenter une mauvaise tenue sous déformation, et sont donc inadaptées à une mise en œ uvre sur un substrat flexible. Les nanofils d'argent sont quant à eux particulièrement complexes à produire. De plus, leur conductivité est dégradée par les résistances de contact existant entre les nanofils dues à la présence de résidus de polymère en surface à l'issue de leur production. Le graphène et les nanotubes de carbone sont également complexes à produire et présentent des performances réduites par rapport à l'ITO. Par contraste, les membranes métalliques nanoporeuses ont des performances très élevées comparées à celles de l'ITO, en particulier en termes de conductivité électrique et de flexibilité.

Les techniques existantes de fabrication des membranes métalliques, y inclue celle décrite dans le brevet US6805972B2, font appel à quatre étapes successives. Une couche mince d'un alliage métallique est d'abord déposée sur un support plan. Cette couche mince est par la suite trempée dans une solution acide en phase liquide pour être au moins en partie désalliée. Le « désalliage » désigne l'action par laquelle au moins un élément métallique de la couche mince est éliminé, afin de former la membrane métallique nanoporeuse. Ainsi, suite à une réaction d'oxydoréduction, l'élément métallique le moins noble de l'alliage, c'est-à-dire l'élément métallique ayant le plus faible potentiel standard d'oxydoréduction avec un acide, est gravé chimiquement sur le substrat. Ne restent alors que les composantes de la couche mince formant la membrane métallique. Cette membrane, dans le cas d'un dépôt sur un substrat ayant une faible adhérence avec le dépôt, du fait de son immersion dans la solution acide, se désolidarise du substrat pour remonter à la surface de la solution acide. La membrane est par la suite récoltée à la surface de la solution acide au moyen d'un rouleau en graphite.

Xuelin Quan et al décrit également dans "Development of nanoporous gold electrodes for electrochemical applications", Microelectronic Engineering, vol.88, n°8, pp 2379-2381, un procédé similaire de désalliage en phase liquide pour obtenir une électrode nano-poreuse.

Un inconvénient d'une telle technique de fabrication de membranes métalliques, qui comprend une étape de désalliage en phase liquide, est qu'elle ne peut être mise en œuvre que pour des couches minces d'alliage métallique ayant une épaisseur suffisante pour assurer au matériau une bonne tenue mécanique permettant d'éviter l'agglomération du matériau lors du désalliage en phase liquide.

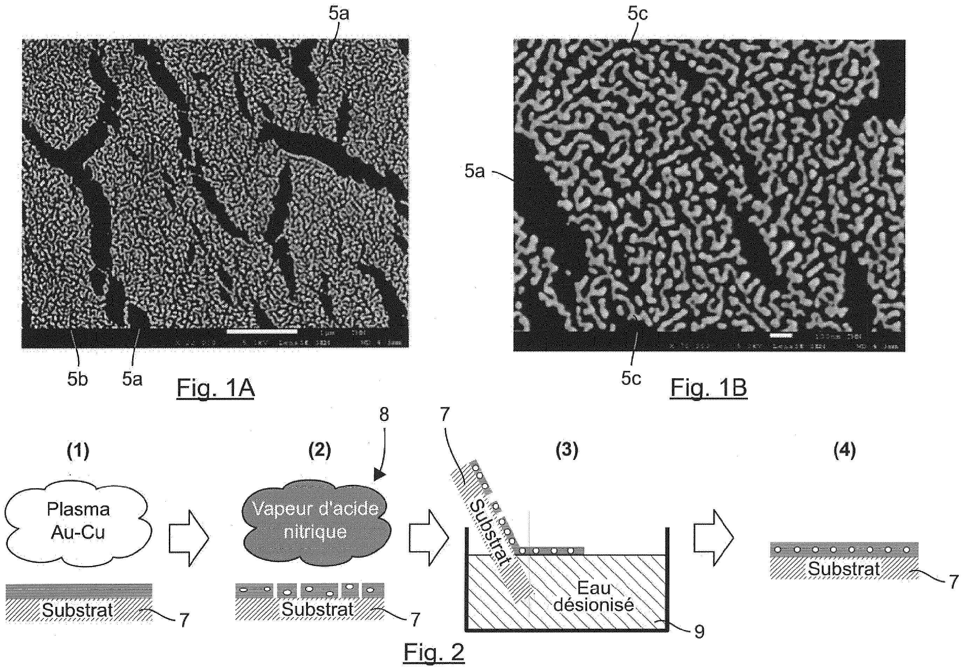

Ainsi, il a été observé que pour de très faibles épaisseurs, la membrane devient particulièrement sensible aux forces de capillarité et de tension de surface générées par le liquide pendant le désalliage (cf. tel qu'illustré par les Figures 1A et 1B, et par l'exemple comparatif décrit au point 5.2.1 de la présente description).

Dans la suite de la description, on entend par « très faible épaisseur » une épaisseur inférieure à 100 nm, préférentiellement comprise entre 1 et 80 nm, préférentiellement comprise entre 3 et 50 nm, préférentiellement comprise entre 5 et 20 nm.

Ainsi, des couches minces préparées selon des procédés connus de l'état de la technique peuvent soit se délaminer et se dégrader lors de leur immersion dans l'acide, soit survivre à l'attaque acide sans délamination ou agglomération du film dans la solution acide, en fonction de la composition de ces couches minces, de leur épaisseur et en fonction de leur adhérence au substrat.

Dans le premier cas, la membrane formée à la surface du substrat se désagrège en totalité dans la solution acide, rendant de ce fait plus complexe, si ce n'est impossible, son transfert sur un objet à revêtir.

Dans le deuxième cas, le procédé permet l'obtention d'une membrane constituée d'un réseau de domaines métalliques nanomaillés, ces domaines ayant chacun une taille inférieure à 10000 micromètres carrés. Chaque domaine nanomaillé est constitué de nanoligaments métalliques interconnectés. La taille des pores de ces nanomailles est nanométrique. Ces domaines nanomaillés recouvrent la surface du substrat. L'ensemble de ces domaines nanomaillés constitue la membrane nanomaillée. Une telle membrane présente cependant l'inconvénient rédhibitoire d'être isolante électriquement, compte tenu de la présence de microfissures séparant les domaines nanomaillés les uns des autres. Enfin, la membrane risque de se désagréger et d'être détruite lors de son étape de décollement et de transfert sur un substrat. Un problème de stabilité des nanoligaments a de plus été révélé lors du vieillissement des membranes. Ce problème s'explique par une transformation des nanoligaments en nanobilles.

Une telle technique de fabrication ne permet donc pas l'obtention de membranes de très faible épaisseur qui soient électriquement conductrices.

Or, il a été observé qu'il était nécessaire, pour obtenir une membrane de transparence satisfaisante dans le spectre visible, de réduire l'épaisseur de la couche mince de film d'alliage initiale à une valeur de 100 nm ou moins.

Une telle technique de fabrication ne permet donc pas d'obtenir des membranes conductrices présentant une transparence satisfaisante.

Les techniques traditionnelles de fabrication de membranes métalliques sont donc inadaptées à la production de membranes métalliques conductrices présentant une transparence satisfaisante. Il existe donc un besoin de fournir un procédé de fabrication d'une membrane qui ne présente pas les inconvénients précités.

### 3. Résumé

L'invention décrite ci-dessous répond à ce besoin. Plus particulièrement, dans au moins un mode de réalisation, l'invention se rapporte à un procédé de préparation d'une membrane composée d'un réseau percolé de domaines nanomaillés métalliques comprenant au moins une étape de désalliage d'une couche mince d'un alliage métallique déposée sur un substrat, ledit procédé étant caractérisé en ce que ladite couche mince présente une épaisseur comprise entre 1 et 100 nm, et en ce que ladite étape de désalliage est réalisée par exposition de ladite couche mince à une vapeur acide issue de la vaporisation d'une solution acide, afin de former le réseau de domaines nanomaillés métalliques. Cette étape conduit les domaines nanomaillés à être séparés de leurs voisins par une distance moyenne de quelques dizaines de microns.

Le terme « domaine nanomaillé métallique » désigne un réseau de ligaments métalliques de taille nanométrique interconnectés. Les pores des nanomailles ont des tailles qui varient entre 10 et 100 nm. Le terme « désalliage » se réfère ci-contre à l'élimination d'au moins un élément métallique de la couche mince, afin de former la membrane avec son réseau de domaines nanomaillés. Le terme « membrane nanomaillée » désigne l'ensemble du réseau de domaines nanomaillés. Le terme « vapeur acide » se réfère à la forme gazeuse émise par une solution acide lors de son évaporation. L'évaporation correspond à la transition du produit de l'état liquide à l'état gazeux. L'état gazeux est un état de la matière dans lequel cette dernière n'a pas de forme propre, ni de volume propre. Un gaz tend ainsi à occuper tout le volume disponible. Par opposition, la « phase liquide » se réfère à un état de la matière dans lequel cette dernière occupe un volume propre, qui ne dépend que de la température par effet de dilatation thermique. La résistance électrique de la couche mince est exprimée sous forme de résistance par carré, qui est dimensionnellement équivalente à l'Ohm, mais dont le symbole est Ω/carré.

La nature du substrat choisi pour servir de support à la couche mince d'alliage métallique à la base de la réalisation de la membrane peut varier d'un mode de réalisation à un autre. Cette composition est choisie de manière à ce que les éléments métalliques destinés à former la membrane présentent le moins d'affinité chimique possible avec le substrat choisi. Ceci réduit l'adhésion de l'alliage au substrat et facilite en conséquence l'étape subséquente de décollement de cette membrane préalable à l'étape de transfert. De plus, le substrat ne doit pas se désagréger ou réagir avec les vapeurs d'acide ni la solution utilisée pour le décollement de la membrane.

Ledit substrat peut être choisi de préférence parmi le groupe des verres silicatés et sodocalciques.

Selon la définition de Lewis, un acide est un composé chimique qui peut, au cours d'une réaction, accepter une paire d'électrons. Selon la théorie de Brønsted, un acide est une espèce qui peut libérer un proton. Le choix dudit acide est déterminé par la composition de l'alliage qu'il conviendra de désallier.

Un procédé de préparation d'une membrane constituée de domaines nanomaillés métalliques selon l'invention repose sur une approche nouvelle et inventive consistant à désallier une couche mince métallique par exposition de cette dernière à une vapeur acide et non à un liquide constitué d'une solution acide. Les inventeurs ont mis en avant que dans ces conditions, le désalliage se passe dans une phase liquide à volume très faible. Cela s'explique par la condensation de la vapeur acide qui forme une couche ultramince d'acide concentré en surface de la couche mince métallique. Le désalliage se déroule dans cette couche d'acide ultramince permettant de désallier l'alliage tout en maintenant une tension de surface très faible. Par conséquent, l'adhésion capillaire de la couche mince désalliée à l'acide est également réduite, ce qui permet de limiter significativement le phénomène de désagrégation de la membrane au cours de l'étape de désalliage. Un procédé selon l'invention permet ainsi la préparation d'une membrane constituée de domaines nanomaillés métalliques présentant une épaisseur comprise entre 1 et 100 nm, pour une surface de taille macroscopique.

De plus, les inventeurs ont mis en avant que de manière surprenante, le désalliage de la couche mince métallique par une vapeur acide conduit à une nanostructuration spécifique de la membrane métallique, avec la formation d'un réseau de domaines nanomaillés métalliques formés de nanoligaments métalliques interconnectés, ces nanomailles ayant chacun une taille inférieure à 10000 micromètres carrés.

Une membrane constituée de domaines nanomaillés métalliques préparée selon l'invention présente une morphologie particulière conduisant à une excellente flexibilité et à des propriétés de transparence et de conductivité électriques particulièrement avantageuses. La transparence dans le spectre visible peut varier entre 78% et 85 %, pour des résistances par carré variant respectivement entre 44 et 1700 Ohm/carré. La transparence peut atteindre 78 % dans le spectre visible, pour une résistance électrique inférieure ou égale à 44 Ohms par carré.

Selon un mode de réalisation particulier, ledit alliage métallique comprend au moins un premier élément métallique, noté A, destiné à entrer dans la composition de ladite membrane, et au moins un deuxième élément métallique, noté B, destiné à être gravé chimiquement sur ledit substrat. On parle alors d'alliage binaire. Le potentiel standard d'oxydoréduction dudit premier élément A avec un acide est supérieur au potentiel standard d'oxydoréduction du deuxième élément métallique B avec un acide. La concentration atomique dudit deuxième élément métallique B dans ladite couche mince métallique est supérieure à un seuil prédéterminé en-dessous duquel la gravure chimique dudit deuxième élément métallique sur ledit substrat est réduite.

Ce seuil prédéterminé de concentration de l'élément B le moins noble de l'alliage est également appelé « parting limit ». Par « élément le moins noble », on entend l'élément ayant le plus faible potentiel standard d'oxydoréduction avec un acide.

Le potentiel d'oxydoréduction, ou potentiel redox, est une grandeur empirique exprimée en volt (de symbole V) et notée E°(Mn+/M) avec (M) un métal quelconque. Cette mesure est appliquée aux couples d'oxydo-réduction pour prévoir la réactivité des espèces chimiques entre elles. Par convention, le potentiel standard E° est mesuré par rapport au couple proton/hydrogène (H+/ H₂), de potentiel nul.

Ledit premier élément métallique peut être choisi préférentiellement parmi le groupe constitué de l'or, le platine, l'argent, le zinc, le nickel et le cuivre. Ledit deuxième élément métallique peut être choisi préférentiellement parmi le groupe constitué de l'argent, le cuivre et l'aluminium. Lesdits premier et deuxième éléments métalliques sont différents l'un de l'autre.

Ledit alliage métallique peut être choisi préférentiellement parmi le groupe constitué des alliages or-argent, or-cuivre, argent-aluminium, zinc-cuivre, platine-cuivre, platine-argent, nickel-aluminium et cuivre-aluminium.

A titre d'exemple, dans le cadre d'un alliage or-cuivre, le cuivre est l'élément le moins noble de l'alliage puisque le potentiel standard d'oxydoréduction du cuivre en ions Cu²⁺, qui est de +0.34 V, est inférieur au potentiel standard d'oxydoréduction de l'or, qui est de +1.83 V. La différence entre les potentiels permet la dissolution sélective de cuivre en présence d'acide. Dans ce cadre, le « parting limit » est d'environ 40% atomique de cuivre. A noter que la valeur de seuil dépend de la composition de l'alliage métallique et sa détermination est considérée comme évidente pour l'Homme du Métier, notamment au vu de ses connaissances générales.

Ainsi, cette valeur de seuil est d'environ :
- 40% atomique de cuivre pour l'alliage or-cuivre,
- 60% atomique d'argent pour l'alliage or-argent.

Selon un mode de réalisation particulier, ledit alliage métallique comprend une pluralité de premiers éléments métalliques, au moins deux éléments issus d'un groupe noté A', destinés à entrer dans la composition de ladite membrane métallique nanomaillée, et au moins un troisième élément métallique issu d'un groupe noté B', destiné à être gravé chimiquement sur ledit substrat. Lorsque l'alliage métallique comprend deux premiers éléments métalliques du groupe A' et un élément du groupe B', on parle d'alliage ternaire.

Les premiers éléments métalliques du groupe A', destinés à entrer dans la composition de ladite membrane, peuvent avantageusement avoir pour fonction d'améliorer une ou plusieurs caractéristiques physico-chimiques de la membrane métallique, en renforçant par exemple la résistance de la membrane à l'oxydation. L'élément du groupe B' est éliminé lors de l'opération de désalliage. Le désalliage conduit donc à la formation d'une membrane nanomaillée dont les mailles sont composées d'un alliage des deux premiers éléments métalliques du groupe A'. La condition nécessaire à la réussite de cette opération de désalliage est que le potentiel d'oxydation de l'élément du groupe B' soit plus petit que celui des éléments métalliques du groupe A'.

Les premiers éléments métalliques du groupe A' peuvent être choisis préférentiellement parmi le groupe constitué de l'or, le platine, l'argent, le zinc, le nickel et le cuivre. Le deuxième élément métallique du groupe B' peut être choisi préférentiellement parmi le groupe constitué du cuivre, l'aluminium, le magnésium et l'argent. Les deux premiers éléments métalliques du groupe A' et l'élément métallique du groupe B' sont différents les uns les autres. Le potentiel standard d'oxydoréduction desdits premiers éléments du groupe A' avec un acide est supérieur au potentiel standard d'oxydoréduction de l'élément métallique du groupe B' avec un acide.

Ledit alliage composé de trois éléments métalliques ou plus peut être choisi préférentiellement parmi le groupe constitué des alliages ternaires nickel-cuivre-magnésium, nickel-argent-magnésium, nickel-cuivre-aluminium, et nickel-argent-aluminium.

Selon un mode de réalisation particulier, ladite couche mince a une épaisseur inférieure à 100 nm, de préférence comprise entre 1 et 80 nm, préférentiellement entre 3 et 50 nm, préférentiellement entre 5 et 20 nm.

Il a été observé que les valeurs optimales de transparence et de conductivité électrique de la membrane sont atteintes lorsque l'épaisseur de la couche mince initiale est comprise entre 5 et 20 nm. A noter de plus que lorsque l'épaisseur de la membrane augmente, la conductivité électrique augmente aussi tandis que sa transparence diminue, et inversement. Un facteur de mérite de *Haacke* exprime l'adaptation de la membrane à une utilisation en tant que revêtement transparent conducteur et est connu de l'état de la technique. Le choix d'une plage d'épaisseur plus restreinte permet d'optimiser ce facteur de performance, et donc d'améliorer l'adaptation de la membrane à une utilisation en tant que revêtement transparent conducteur. Une membrane constituée de domaines nanomaillés métallique préparée selon l'invention peut avantageusement présenter un facteur de mérite de *Haacke* de 2,13×10⁻³ Ω⁻¹.

Selon un mode de réalisation particulier, le procédé de préparation comprend une étape de décollement de ladite membrane nanomaillée dudit substrat par trempage dans une solution de décollement.

On entend par « solution de décollement » une solution qui présente le moins d'affinité chimique possible avec la membrane nanomaillée, de manière à limiter les risques de réaction chimique entre la membrane métallique et cette solution.

De manière préférentielle, cette solution de décollement est constituée d'eau désionisée.

Une membrane métallique nanomaillée selon l'invention peut être aisément décollée du substrat afin d'être récupérée sur n'importe quel type de surface d'objet à revêtir. Suite à l'étape de décollement, la membrane métallique nanomaillée flotte à la surface de la solution de décollement.

Selon un mode de réalisation particulier, le procédé de préparation comprend une étape ultérieure de transfert de ladite membrane nanomaillée sur la surface d'un objet à revêtir par immersion d'une portion de surface dudit objet dans ladite solution de décollement.

Lors de cette étape, la membrane nanomaillée forme un revêtement continu sur l'ensemble de cette portion de surface immergée de l'objet. C'est dans cette étape que se réalise la percolation des domaines nanomaillés métalliques qui forment ainsi une membrane continue.

Selon un mode de réalisation particulier, le procédé de préparation comprend une étape de dépôt de ladite couche mince métallique sur ledit substrat par pulvérisation cathodique ou par co-pulvérisation cathodique.

Selon des modes de réalisation alternatifs, cette étape de dépôt est mise en œuvre par évaporation ou co-évaporation (thermique ou par canon à électrons), par dépôt chimique en phase vapeur, par ablation laser ou via tout procédé connu permettant de synthétiser un alliage sous la forme d'une couche mince.

Ainsi, la présente invention permet l'obtention d'une membrane constituée de domaines nanomaillés métalliques par mise en œuvre d'un procédé comprenant les étapes suivantes :
- une étape de dépôt sur un substrat d'une couche mince d'un alliage métallique, présentant une épaisseur comprise entre 1 et 100 nm, par pulvérisation cathodique ou par co-pulvérisation cathodique ;
- une étape de désalliage de ladite couche mince par exposition à une vapeur acide, afin de former ladite membrane métallique nanomaillée ;
- une étape de décollement de ladite membrane nanomaillée dudit substrat par trempage dans une solution de décollement ;
- une étape ultérieure de transfert de ladite membrane nanomaillée sur un objet par immersion d'une portion de surface dudit objet dans ladite solution de décollement.

Un tel procédé de dépôt a pour avantage de permettre la formation d'une couche mince métallique dont la concentration est choisie avec précision. Il est donc particulièrement adapté pour la préparation d'une couche mince en vue d'une étape subséquente de désalliage.

L'invention concerne également une membrane métallique nanomaillée obtenue par un procédé de préparation tel que celui décrit ci-dessus.

L'invention concerne également une membrane métallique nanomaillée susceptible d'être obtenue par le procédé de préparation tel que celui décrit ci-dessus, caractérisée en ce que son épaisseur est comprise entre 1 et 100 nm.

Tel que discuté précédemment, une telle membrane métallique nanomaillée présente une excellente flexibilité et des propriétés de transparence et de conductivité électriques particulièrement avantageuses.

La transparence peut atteindre 78% dans le spectre visible, avec une résistance électrique inférieure ou égale à 44 Ohms par carré.

L'invention concerne également l'utilisation d'une telle membrane métallique nanomaillée, comme revêtement pour la conduction électrique.

L'invention concerne également l'utilisation d'une telle membrane métallique nanomaillée, comme revêtement conducteur flexible et extensible pouvant subir des déformations tout en gardant ses propriétés conductrices et transparentes. A titre d'exemple, une telle membrane peut être utilisée comme revêtement pour la conduction électrique de la surface d'un écran tactile flexible. L'utilisation d'une telle membrane pour le revêtement d'un gant de laboratoire en nitrile ou latex peut permettre de détecter l'apparition d'une déchirure, cette dernière provoquant une augmentation de résistance électrique de la membrane.

### 4. Figures

Des caractéristiques et avantages de l'invention apparaîtront à la lecture de la description suivante d'un mode de réalisation particulier, donné à titre d'exemple illustratif et non limitatif, et des figures annexées parmi lesquelles :
- la Figure 1A est une image par microscopie électronique à balayage (MEB) en plein champ, à une échelle d'1 µm, d'une membrane d'or nanomaillée obtenue par désalliage d'une couche d'alliage or-cuivre dans de l'acide nitrique en phase liquide, selon un procédé connu de l'état de la technique,
- la Figure 1B est une image MEB en plein champ, à une échelle de 100 nm, d'une membrane d'or nanomaillée obtenue par désalliage d'une couche d'alliage or-cuivre dans de l'acide nitrique en phase liquide, selon un procédé connu de l'état de la technique,
- la Figure 2 illustre schématiquement les étapes successives d'un procédé de préparation d'une membrane métallique nanomaillée selon un mode de réalisation particulier de l'invention,
- la Figure 3A est une image MEB en plein champ, à une échelle d'1 µm, d'une membrane d'or nanomaillée selon un mode de réalisation de l'invention, après transfert sur un support transparent et flexible en PET,
- la Figure 3B est une image MEB en plein champ, à une échelle de 100 nm, d'une membrane d'or nanomaillée selon un mode de réalisation de l'invention, après transfert sur un support transparent et flexible en PET,
- la Figure 4 est un graphique illustrant les variations de transmittance optique à une longueur d'onde de 550 nm pour différents types de membranes ou couches minces, en fonction de leur résistance électrique par carré,
- la Figure 5A est une photographie représentant le dispositif expérimental mis en œuvre pour un test de tenue en fatigue d'une membrane d'or nanomaillée selon un mode de réalisation de l'invention qui subit des cycles de courbure,
- la Figure 5B est un graphique illustrant les variations respectives de résistance électrique d'une membrane d'or nanomaillée selon un mode de réalisation de l'invention, et d'une couche mince, en fonction du nombre d'itération de leur déformation de 1%.

Les différents éléments illustrés par les figures ne sont pas nécessairement représentés à l'échelle réelle, l'accent étant davantage porté sur la représentation du fonctionnement général de l'invention.

### 5. Description détaillée d'un mode de réalisation particulier de l'invention

Le concept général d'un procédé de préparation d'une membrane métallique nanomaillée selon un mode de réalisation de l'invention est de mettre en œuvre une étape de désalliage d'une couche mince initiale d'un alliage métallique au cours de laquelle cette dernière est exposée à une vapeur acide, et non à un liquide constitué d'une solution acide. Un mode de réalisation particulier de l'invention est présenté dans la suite de la description. Il est bien entendu que la présente invention n'est nullement limitée par ce mode de réalisation particulier et que d'autres modes de réalisation peuvent parfaitement être mis en œuvre.

### 5.1 Procédé de préparation d'une membrane métallique nanomaillée

Tel qu'illustré par la **Figure 2**, un procédé de fabrication d'une membrane métallique nanomaillée 5 comprend, selon un mode de réalisation particulier de l'invention, une première étape de dépôt 1 d'une couche mince 6 sur un substrat 7, suivie d'une deuxième étape de désalliage 2 de cette couche mince 6 par exposition à une vapeur acide 8, qui permet l'obtention de la membrane 5, suivie d'une troisième étape de décollement 3 de cette membrane 5 du substrat 7 par trempage dans une solution dédiée 9, et d'une étape finale de transfert de cette membrane 5 sur la surface d'un objet à revêtir 10.

Au cours de l'étape de dépôt 1, une couche mince 6 composée d'un alliage binaire or-cuivre (Au-Cu) est déposée sur un substrat 7 en verre. Au sein de cet alliage métallique, et tel que détaillé dans la suite de la description, l'or est destiné à entrer dans la composition de la future membrane 5 tandis que le cuivre est destiné à être gravé chimiquement sur le substrat 7 au cours d'une étape subséquente de désalliage 2 de la couche mince 6.

Selon des modes de réalisations alternatifs toute combinaison d'éléments métalliques peut être utilisée pour former la couche mince 6, sous réserve que l'écart entre les potentiels standards d'oxydoréduction de ces derniers soit suffisamment élevé pour permettre leur désalliage. Ainsi, de manière connue, dans le cas d'un alliage métallique comprenant au moins un premier élément métallique destiné à entrer dans la composition de ladite membrane 5, et au moins un deuxième élément métallique destiné à être gravé chimiquement sur le substrat 7 après exposition à une vapeur acide 8, il est souhaitable que le premier élément métallique présente un potentiel d'oxydation électrochimique E°1 avec l'acide 8 supérieur au potentiel d'oxydation électrochimique E°2 du deuxième élément métallique avec ce même acide 8.

La compréhension du processus de désalliage ne se limite cependant pas aux seules différences existantes entre les potentiels d'oxydoréduction respectifs des différents éléments constituant l'alliage.

Certes, ces différences de potentiels d'oxydation sont un point à considérer lorsqu'on travaille avec des métaux nobles tels que l'or et le platine (Pt). Par exemple, pour réaliser de l'or nanoporeux ou une membrane nanomaillée 5 d'or, les alliages binaires les plus utilisés sont les alliages or-cuivre et or-argent. Le potentiel standard d'oxydoréduction de l'argent solide en ion Ag⁺ est de +0.8 V alors que celui du cuivre solide en ions Cu²⁺ est de +0.34 V. Le potentiel standard d'oxydoréduction de l'or est de +1.83 V. La différence entre les potentiels permet la dissolution sélective de cuivre ou d'argent.

En revanche, pour réaliser un désalliage à base de métaux autres que l'or ou le platine tels que le cuivre ou l'argent par exemple, d'autres paramètres ayant une influence sur la réaction chimique de désalliage doivent également être pris en compte. Par exemple, dans le cas d'un alliage argent-aluminium, on peut graver de l'aluminium dans une solution d'acide chlorhydrique afin d'obtenir de l'argent nanoporeux ou une membrane d'argent nanomaillée 5. Cependant, ce n'est pas uniquement la différence de potentiels qui permet cette dissolution sélective mais aussi la prise en compte de la formation d'une couche de chlorure d'argent en surface de l'argent métallique, cette même couche protégeant l'argent de la dissolution au cours du désalliage.

Des exemples non limitatifs d'alliages métalliques binaires pouvant être utilisés comprennent les alliages or-argent, or-cuivre, zinc-cuivre, platine-cuivre, nickel-aluminium et cuivre-aluminium.

Selon un mode de réalisation alternatif, l'alliage métallique constituant la couche mince initiale 6 peut également être composé de trois éléments métalliques (on parle alors d'alliage ternaire) ou plus. Dans ce cas, Il peut être prévu d'éliminer un seul élément de l'alliage ternaire afin d'obtenir une membrane d'alliage binaire.

L'élément métallique additionnel, destiné à entrer avec le premier élément métallique dans la composition de ladite membrane, peut avantageusement avoir pour fonction d'améliorer une ou plusieurs caractéristiques physico-chimiques de la membrane métallique.

Ainsi, à titre d'exemple non limitatif, la couche mince 6 peut être constituée d'un alliage ternaire nickel-cuivre-magnésium, dans lequel le magnésium est destiné à être gravé sur le substrat tandis que le cuivre et le nickel sont destinés à entrer dans la composition finale de la membrane métallique 5. Le nickel a alors pour fonction d'accroître la résistante du cuivre à l'oxydation.

De manière alternative, plusieurs alliages ternaires peuvent être considérés, tels que des alliages de nickel-argent-magnésium, de nickel-cuivre-aluminium, ou de nickel-argent-aluminium.

Pour revenir à la couche mince constituée d'un alliage binaire or-cuivre, la concentration atomique du cuivre est fixée à 40% atomique. Ce seuil de concentration de l'élément le moins noble de l'alliage, appelé « parting limit », correspond à la valeur de concentration en-dessous de laquelle la dissolution de cet élément le moins noble est réduite. Ceci est lié à la formation d'une couche de passivation de l'élément le plus noble tout au début de processus de désalliage, du fait de sa forte concentration dans l'alliage. Cette couche de passivation agit comme une couche de protection qui empêche la pénétration de la solution acide dans l'alliage et empêche donc la dissolution de l'élément le moins noble de volume de l'alliage. Dans le cadre du processus de désalliage, il est préférable que la concentration de l'élément le moins noble soit supérieure à cette concentration seuil « parting limit ». Dans le cas de l'or-cuivre, la concentration seuil de dissolution et de 40% de cuivre tandis que dans le cas d'Au-Ag, ce seuil est de 60% d'argent, tel que discuté dans la publication « Unusual Dealloying Effect in Gold/Copper Alloy Thin Films: The Role of Defects and Column Boundaries in the Formation of Nanoporous Gold », par El Mel, A.-A.; Boukli-Hacene, F.; Molina-Luna, L.; Bouts, N.; Chauvin, A.; Thiry, D.; Gautron, E.; Gautier, N.; Tessier, P.-Y, ACS Appl. Mater. Interfaces 2015, 7, 2310-2321.

Selon des modes de réalisations alternatifs, l'épaisseur de la couche mince 6 peut varier entre 1 et 100 nm, ceci conduisant à l'obtention de membranes métalliques 5 présentant des variations de conductivité et de transparence. Dans ce contexte et tel que discuté dans la suite de la description, il a été observé que lorsque l'épaisseur de la membrane 5 augmente, la conductivité électrique augmente aussi tandis que sa transparence diminue, et inversement.

La composition du substrat 7 choisi pour servir de support à la couche mince d'alliage métallique 6 à la base de la réalisation de la membrane 5 peut varier d'un mode de réalisation à un autre. Cette composition est choisie de manière à ce que les éléments métalliques destinés à former la membrane 5 présentent le moins d'affinité chimique possible avec le substrat 7 choisi. Ceci réduit l'adhésion de l'alliage au substrat et facilite en conséquence l'étape subséquente de décollement de cette membrane 5. De plus, le substrat ne doit pas se désagréger ou réagir avec les vapeurs d'acide ni la solution utilisée pour le décollement de la membrane 5. A titre d'exemple non limitatif, et tel qu'illustré par la Figure 2, l'utilisation d'un substrat en verre permet de remplir ces exigences dans le cas des membranes nanomaillées 5 préparées par gravure en phase vapeur d'une couche d'or-cuivre. En effet, le ou les éléments métalliques restant après le désalliage interagissent très faiblement avec le substrat 7 et la membrane 5 se délamine très facilement. De plus, le verre ne réagit pas avec l'acide utilisé dans le procédé.

*A contrario,* dans le cadre de la formation d'une membrane d'argent par désalliage d'une couche d'argent-aluminium dans de l'acide chlorhydrique, l'utilisation d'un substrat en verre est inappropriée, compte tenu de son fort potentiel de réaction avec cet acide.

Selon des modes de réalisations alternatifs, tout type de substrat présentant de manière connue une faible affinité avec la couche mince considérée peut être utilisé.

Tel qu'illustré par la Figure 2, le dépôt de la couche mince 6 est mis en œuvre par co-pulvérisation cathodique magnétron. Une telle technique a pour avantage de permettre la formation d'une couche mince dont la concentration est maîtrisée avec précision. Sa mise en œuvre est donc particulièrement avantageuse pour la préparation d'une couche mince 6 avant désalliage.

Selon des modes de réalisation alternatifs, cette étape de dépôt 1 est mise en œuvre par pulvérisation cathodique d'un alliage, évaporation ou co-évaporation (thermique ou par canon à électrons), par dépôt chimique en phase vapeur, par ablation laser ou via tout procédé connu permettant de synthétiser un alliage sous forme d'une couche mince.

Au cours de l'étape de désalliage 2, la couche mince 6 d'or-cuivre est désalliée par exposition à une vapeur d'acide nitrique 8. A cet effet, l'acide nitrique 8 oxyde et grave sélectivement l'élément métallique ayant le potentiel d'oxydation avec l'acide nitrique le plus bas, en l'espèce : le cuivre. L'élimination par gravure du métal le moins noble et la réorganisation du métal le plus noble conduisent à la formation de domaines nanomaillés métalliques 5b constitués de nanoligaments métalliques 5c interconnectés, ces domaines 5b couvrant la surface du substrat 7 et ayant chacun une taille inférieure à 10000 micromètres carrés. L'ensemble de ces domaines 5b constitue la membrane nanomaillée 5. En choisissant l'alliage précurseur, on peut définir le métal formant la membrane 5, en l'espèce : l'or.

Un point essentiel du procédé de fabrication selon l'invention réside dans le fait que l'acide nitrique servant au désalliage se présente sous forme de vapeur, et non liquide. En effet, et tel que décrit dans l'exposé de l'art antérieur, une immersion directe de la couche mince 6 dans une solution d'acide nitrique provoquerait sa désagrégation complète compte tenu des forces de capillarité générées à l'interface entre la couche mince et la solution acide. Au contraire, l'exposition de la couche mince 6 à une vapeur acide 8 permet de limiter significativement le phénomène de désagrégation de cette dernière. En effet, les inventeurs ont mis en avant que de manière surprenante, dans ces conditions, le désalliage se passe dans une phase liquide à volume très faible. Cela s'explique par la condensation de la vapeur acide qui forme une couche ultramince d'acide concentré en surface de la couche mince métallique. Le désalliage se déroule dans cette couche d'acide ultramince permettant de désallier l'alliage tout en maintenant une tension de surface très faible. Par conséquent, l'adhésion capillaire de la couche mince 6 désalliée, c'est-à-dire la membrane 5, à l'acide 8 est également réduite, ce qui limite les contraintes générées au sein de la membrane 5, l'apparition et/ou le développement de fissures et les risques de délamination.

L'étape de désalliage 2 permet ainsi l'obtention, après désalliage 2 d'une couche mince 6 d'or-cuivre, d'une membrane métallique nanomaillée 5 d'or présentant une épaisseur inférieure à 100 nm, pour une surface de taille macroscopique.

Une fois la membrane 5 d'or formée à la surface du substrat de verre 7, ce dernier est immergé 3 dans une solution d'eau désionisée 9 afin de décoller la membrane 5 du substrat 7. L'eau désionisée 9 a pour avantage de ne présenter qu'une très faible affinité chimique avec l'or. Un tel choix permet ainsi de limiter les risques de solubilisation de la membrane 5. Suite à l'immersion du substrat 7, la membrane 5, qui est hydrophobe, est décollée de la lame de verre, qui elle est hydrophile. A la suite de l'étape de trempage 3, la membrane métallique nanomaillée d'or 5 flotte à la surface de la solution d'eau désionisée 9 sans qu'elle ne se désagrège. Pour une couche de l'état de la technique qui aurait été désalliée en phase liquide sans subir de désagrégation dans l'acide, elle se désagrègerait lors du trempage dans l'eau. La désagrégation n'est ainsi pas limitée uniquement à l'étape de désalliage 2, mais elle peut survenir également lors de l'étape de trempage 3 dans la solution 9 de décollement. L'étape de désalliage 2 à partir d'une vapeur acide 8 permet d'éviter cette désagrégation.

La composition de la solution 9 de décollement peut à l'évidence varier d'un mode de réalisation à un autre, cette dernière étant choisie de manière à ce que les éléments métalliques formant la membrane 5 présentent le moins d'affinité chimique possible avec la solution 9 choisie.

Afin de procéder au transfert 4 de la membrane 5 sur un objet à revêtir 10, une portion de surface de cet objet 10 est immergée dans la solution d'eau désionisée 9 à la surface de laquelle flotte la membrane 5. Lors de cette étape de transfert 4, il y a percolation des domaines métalliques nanomaillés qui forment ainsi une membrane nanomaillée continue 5 sur toute la portion de surface immergée de l'objet 10.

Selon des modes de réalisation particuliers de l'invention, cet objet à revêtir 10 peut prendre la forme d'une cellule solaire, d'une surface flexible et extensible, d'une membrane échangeuse de protons (PEM), d'un composé de PET, de polydiméthylsiloxane (PDMS), de silicium et/ou de verre, ou de tout autre support pouvant bénéficier des propriétés avantageuses de la membrane 5 dans le cadre d'une application industrielle particulière. Par ailleurs la surface de l'objet à revêtir 10 peut être plane, réglée ou gauche sans que les propriétés conductrices et transparentes n'en soient altérées. Par exemple, cette surface 10 peut être celle d'un cylindre, d'un cône, d'une sphère ou d'un ellipsoïde. La surface de l'objet à revêtir 10 peut également être de forme plus complexe avec une surface pouvant comporter à la fois des parties planes, non planes, réglées et/ou gauches. Par exemple il peut s'agit d'un flacon, d'un tube ou d'une bouteille, notamment en verre ou en polymère ou à tout type de matériaux. Par exemple, la membrane 5 peut être transférée sur la surface d'un tube en verre (i.e. surface non plane) : cette surface reste toujours transparente, et la conductivité de l'objet ainsi revêtu permet d'allumer une LED (photographies non montrées).

Selon un mode de réalisation de l'invention, la membrane 5 ainsi obtenue est utilisée comme revêtement pour la conduction électrique, par exemple sur la surface d'un écran tactile, cet écran pouvant être flexible.

Selon un mode de réalisation alternatif, la membrane 5 est utilisée comme revêtement pour la détection de ruptures de la surface d'un objet 10, la résistance électrique de la membrane variant en fonction de ces dernières. A titre d'exemple, l'utilisation d'une telle membrane 5 pour le revêtement d'un gant de laboratoire en nitrile ou latex peut permettre de détecter l'apparition d'une déchirure.

### 5.2 Caractérisation d'une membrane métallique nanomaillée

Dans la suite de la description, une membrane nanomaillée 5 d'or produite selon un mode de réalisation de l'invention a fait l'objet d'observations au MEB, de tests de transmittance optique et de résistance électrique par carré, et de tests de tenue en courbure.

### 5.2.1 Observations au microscope électronique à balayage

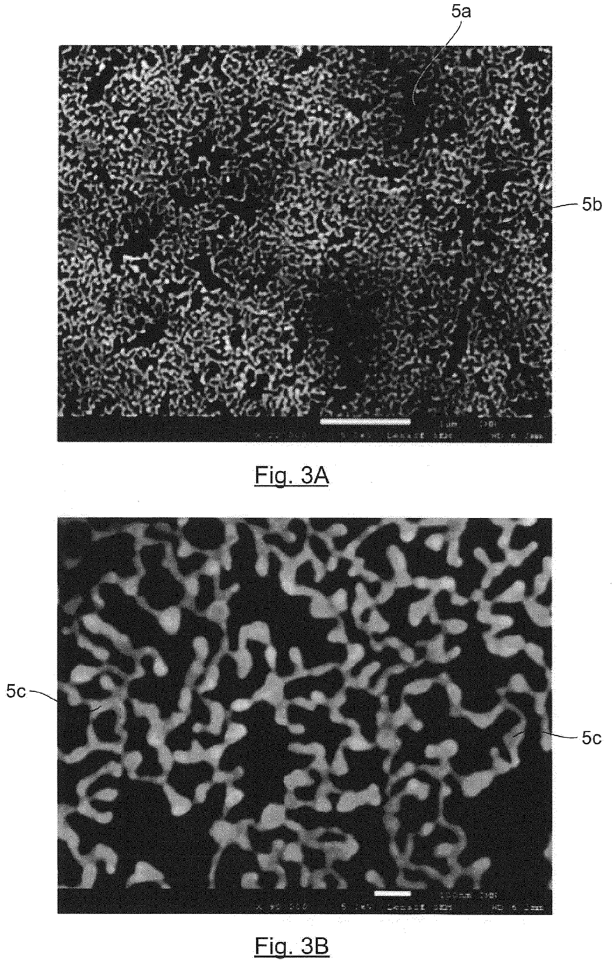

Les Figures 3A et 3B sont des images obtenues par observation au MEB en plein champ, à une échelle respective d'1 µm et de 100 nm, d'une membrane d'or nanomaillée 5 obtenue via un procédé selon un mode de réalisation de l'invention. Plus précisément, cette membrane 5 a été obtenue à partir d'une couche mince 6 d'une épaisseur de 10 nm, constituée d'un alliage d'or-cuivre composé de 24% atomique d'or. La couche mince 6 a dans un premier temps été déposée sur un substrat de verre par co-pulvérisation cathodique magnétron d'une cible d'or et d'une cible de cuivre en position cofocale. La couche mince a par la suite été désalliée par une exposition de 2 heures à de la vapeur d'acide nitrique 8, avant d'être trempée dans de l'eau désionisée 9. Enfin, la membrane obtenue a été transférée sur un support 10 transparent et flexible en PET, pour observation.

A titre d'exemple comparatif, une membrane d'or obtenue selon un procédé connu, à partir d'une couche mince ayant la même composition atomique ainsi que la même épaisseur que celle décrite ci-dessus a également été observée au MEB. La différence majeure existant entre ces deux procédés d'obtention réside dans le fait que selon l'invention, l'étape de désalliage est conduite en phase gazeuse, et non liquide.

Ainsi, la Figure 1A est une image obtenue au microscope électronique à balayage (MEB) en plein champ, à une échelle d'1 µm, qui illustre l'aspect de surface d'une membrane 5 d'or obtenue selon un procédé connu. Le substrat PET utilisé dans cette expérience permet une bonne adhésion de la membrane 5. L'observation de cette membrane 5 révèle la présence de microfissures 5a entre les domaines nanomaillés 5b d'or. Les fissures 5a résultent des contraintes générées pendant le processus de désalliage. La formation de ces fissures 5a et des domaines nanomaillés 5b est notamment décrite dans les publications « In Situ Observation of Strain Development and Porosity Evolution in Nanoporous Gold Foils », par Dotzler, C. J. et al, Adv. Funct. Mater. 21, 3938-3946 (2011), et "Microstructure, stability and thermomechanical behavior of crack-free thin films of nanoporous gold", par Sun, Y., Kucera, K. P., Burger, S. A. & John Balk, Scr. Mater. 58, 1018-1021 (2008). En examinant les domaines 5b, il a été constaté que ces derniers sont formés des nanoligaments 5c déconnectés physiquement les uns des autres. C'est la raison pour laquelle les membranes sont dans ce cas électriquement isolantes. Un problème de stabilité des nanoligaments se rapportant à une transformation des nanoligaments en nanobilles a de plus été révélé lors du vieillissement des membranes. La transformation des ligaments en billes est liée à l'utilisation du PET comme support sur lequel les ligaments d'or adhèrent fortement, ce qui est un facteur limitant la relaxation des contraintes mécaniques des ligaments, générée pendant le processus de désalliage.

Un autre comportement a été observé en utilisant comme support 7 des substrats de verre au lieu du PET ou PDMS. En fonction du taux d'or dans l'alliage et de leurs épaisseurs, les couches peuvent se délaminer et se dégrader lors de leur immersion dans l'acide ou survivre à l'attaque acide sans délamination ou agglomération du film dans la solution acide. Bien que dans ce dernier cas, les domaines nanomaillés sont formés de nanoligaments, la membrane obtenue est isolante électriquement à cause de la présence de microfissures séparant les domaines nanomaillés les uns des autres. Enfin, la membrane se désagrège lors de son trempage dans la solution de décollement et/ou lors de son transfert sur un substrat souple (e.g. PET).

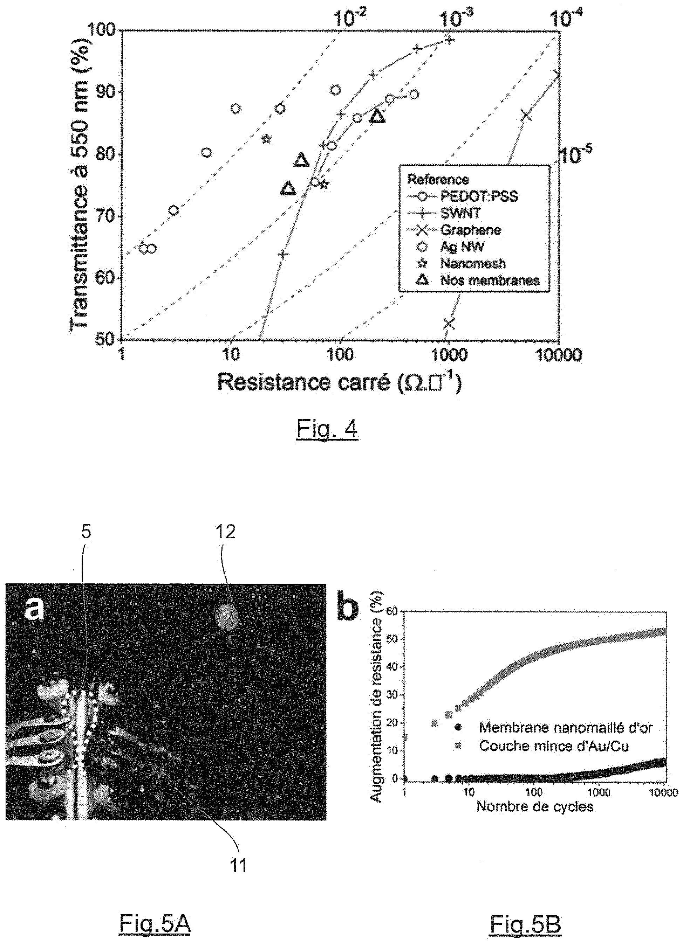

En comparaison avec la Figure 1A, la Figures 3A met en évidence la réduction des fissures 5a séparant les domaines nanomaillés 5b entre eux et la percolation de ces derniers. La Figure 5B permet quant à elle de mettre en évidence les liaisons existant entre les nanoligaments 5c formant chacun de ces domaines nanomaillés 5b. Cette interconnectivité des nanoligaments 5c métalliques entre eux confère à la membrane 5 son aptitude à conduire l'électricité de manière satisfaisante, tel que décrit ci-dessous.

### 5.2.2 Test de transmittance optique et de résistance électrique par carré

Pour ce test, une membrane nanomaillée 5 d'or a été obtenue à partir d'une couche mince 6 constituée d'un alliage d'or-cuivre présentant 17% atomique d'or et 5 nm d'épaisseur à l'état initial. La couche 6 a été créée par co-pulvérisation cathodique magnétron. L'échantillon a ensuite été exposé à une vapeur d'acide nitrique 8 pendant 30 min. La membrane créée 5 a par la suite été transférée sur un support 10 de PET en utilisant de l'eau désionisée 9.

Pour une comparaison des caractéristiques de la membrane étudiée avec les membranes connues, la transmittance à 550 nm ainsi que la résistance par carré de l'échantillon ont été mesurées.

La résistance électrique de la couche mince est exprimée sous forme de résistance par carré, qui est dimensionnellement équivalente à l'Ohm, mais dont le symbole est Ω/□.

La Figure 4 est un graphique exprimant des valeurs de transmittance à 550 nm en fonction de la résistance par carré, notamment pour des membranes connues de l'état de la technique constituées de :
- d'un mélange de poly(3,4-éthylènedioxythiophène) et de poly(styrène sulfonate) de sodium, également connu sous le sigle PEDOT:PSS,
- de nanotubes de carbone,
- de graphène,
- de nanofils d'argent,
- de nanomailles,
A titre de comparaison, les performances de 3 membranes nanomaillées d'or (notées « Nos membranes » réalisées selon un mode de réalisation de l'invention sont représentées aussi sur la figure 4.

Les propriétés du PEDOT:PSS sont décrites dans la publication "Highly Conductive PEDOT:PSS Electrode with Optimized Solvent and Thermal Post-Treatment for ITO-Free organic Solar Cells", par Kim, Y. H. et al., Adv. Funct. Mater. 21, 1076-1081 (2011).

Les propriétés respectives des nanotubes de carbone, du graphène, des nanofils d'argent, et des nanomailles sont décrites dans les publications suivantes :
- "Past achievements and future challenges in the development of optically transparent electrodes", par Ellmer, K, Nat. Photonics 6, 809-817 (2012).
- "A transparent electrode based on a metal nanotrough network", par Wu, H. et al., Nat. Nanotechnol. 8, 421-425 (2013).
- "Silver Nanowire Networks as Flexible, Transparent, Conducting Films: Extremely High DC to Optical Conductivity Ratios", par De, S. et al, ACS Nano 3, 1767-1774 (2009).

Tel qu'illustré par la Figure 4, la membrane étudiée possède une résistance de 44 Ω/□ et une transmittance optique de 79 %. Les valeurs de transmittance optique maximales atteignent 86 % et les valeurs de résistance par carré minimales sont de 33 Ω/□. Ces performances confèrent un facteur de mérite pour cette membrane (en langue anglaise *Haacke's factor of merit*) de 2.13×10⁻³ Ω⁻¹.

A titre de comparaison, la membrane étudiée possède des valeurs de résistance et transmittance comparables à celle de nanotubes de carbone déposés sur PET. Les valeurs de résistance et transmittance sont également comparable aux performances obtenus avec des nanofils d'Argent ou avec des couches de PEDOT:PSS.

Une membrane nanomaillée 5 obtenue selon le procédé décrit ci-dessus présente donc l'avantage d'avoir à la fois une transparence et une conductivité électrique satisfaisantes.

### 5.2.3 Tests de tenue en courbure - Tenue aux déformations

Dans le cadre d'un premier test, dont le dispositif expérimental est représenté par la Figure 5A, une membrane 5 nanomaillée d'or déposée sur un substrat de PET, qui présente les mêmes caractéristiques techniques que la membrane ayant fait l'objet des tests de transmittance optique et de résistance électrique décrits ci-dessus, a été soumise à un effort de flexion entre deux pinces 11. Une LED 12 positionnée en arrière plan de la Figure 5A témoigne du passage ou non du courant électrique au travers de la membrane 5.

Au cours du test, il a été observé que la membrane 5 subit une déformation de 2.5% et reste conducteur (la LED 12 reste allumée, et confirme le passage de courant électrique dans la membrane).

Dans le cadre d'un second test, une membrane 5 d'or telle que celle décrite ci-dessus ainsi qu'une couche mince ayant les mêmes caractéristiques que l'alliage initial or-cuivre décrit ci-dessus ont respectivement subi une déformation de 1% répétée 10 000 fois.

La figure 5B est un graphique illustrant les variations respectives de résistance électrique de la couche mince 6 avant désalliage et de la résistance de la membrane nanomaillée 5 après désalliage de la couche mince 6, en fonction du nombre d'itérations de leur déformation.

A la suite des 10 000 cycles de déformation, il a été observé une augmentation de résistance électrique de moins de 10% dans le cas de la membrane 5 tandis que l'augmentation de résistance électrique de la couche mince 6 est de plus de 50 %.

En comparaison, une couche mince d'oxyde d'indium-étain (ITO) connue de l'état de la technique voit sa résistance électrique augmenter de 2000% après moins de 100 cycles de déformation, tel que décrit dans l'article « A transparent electrode based on a metal nanotrough network », par Wu, H. et al., Nature nanotechnology 8, 421-425 (2013).

La tenue en courbure d'une membrane 5 selon l'invention est donc nettement améliorée en comparaison avec des membranes connues de l'état de la technique.

## Revendications

1. Procédé de préparation d'une membrane métallique nanomaillée (5) comprenant une étape de désalliage (1) d'une couche mince (6) d'un alliage métallique déposée sur un substrat (7), ledit procédé étant **caractérisé en ce que** ladite couche mince (6) présente une épaisseur comprise entre 1 et 100 nm, et **en ce que** ladite étape de désalliage (1) est réalisée par exposition de ladite couche mince (6) à une vapeur acide (8), afin de former ladite membrane métallique nanomaillée (5).

2. Procédé de préparation selon la revendication 1, **caractérisé en ce que** ledit alliage métallique comprend au moins un premier élément métallique destiné à entrer dans la composition de ladite membrane (5), et au moins un deuxième élément métallique destiné à être gravé chimiquement sur ledit substrat (7), le potentiel standard d'oxydoréduction dudit premier élément avec un acide étant supérieur au potentiel standard d'oxydoréduction du deuxième élément métallique avec un acide, la concentration atomique dudit deuxième élément métallique dans ladite couche mince métallique (6) étant supérieure à un seuil prédéterminé en-dessous duquel la gravure chimique dudit deuxième élément métallique sur ledit substrat est réduite.

3. Procédé de préparation selon l'une quelconque des revendications 1 et 2, **caractérisé en ce que** ledit alliage métallique comprend une pluralité de premiers éléments métalliques destinés à entrer dans la composition de ladite membrane métallique nanomaillée (5).

4. Procédé de préparation selon l'une quelconque des revendications 1 à 3, **caractérisé en ce que** ladite couche mince (6) a une épaisseur inférieure à 100 nm, préférentiellement comprise entre 1 et 80 nm, préférentiellement entre 3 et 50 nm, préférentiellement entre 5 et 20 nm.

5. Procédé de préparation d'une membrane métallique nanomaillée (5) selon l'une quelconque des revendications 1 à 4, **caractérisé en ce qu'**il comprend une étape de décollement (3) de ladite membrane nanomaillée (5) dudit substrat (7) par trempage dans une solution de décollement (9).

6. Procédé de préparation selon la revendication 5, **caractérisé en ce qu'**il comprend une étape ultérieure de transfert (4) de ladite membrane nanomaillée (5) sur un objet (10) par immersion d'une portion de surface dudit objet (10) dans ladite solution de décollement (9) entraînant la percolation des domaines nanomaillés.

7. Procédé de préparation selon l'une quelconque des revendications 1 à 6, **caractérisé en ce qu'**il comprend une étape de dépôt (1) de ladite couche mince métallique (6) sur ledit substrat (7) mise en œuvre par pulvérisation cathodique magnétron, pulvérisation cathodique d'un alliage, évaporation, co-évaporation, dépôt chimique en phase vapeur ou ablasion laser.

8. Procédé de préparation selon l'une quelconque des revendications 6 ou 7, **caractérisé en ce que** la surface de l'objet (10) est plane, réglée ou gauche, par exemple cette surface est celle d'un cylindre, d'un cône, d'une sphère ou d'un ellipsoïde ; ou bien la surface de l'objet (10) comporte des parties planes, non planes, réglées et/ou gauches, par exemple cette surface est celle d'un flacon, d'un tube ou d'une bouteille, notamment en verre ou en polymère.

9. Membrane métallique nanomaillée (5) susceptible d'être obtenue par le procédé de préparation selon l'une des revendications 1 à 7, **caractérisée en ce que** son épaisseur est comprise entre 1 et 100 nm.

10. Utilisation d'une membrane métallique nanomaillée (5) selon la revendication 9, comme revêtement transparent pour la conduction électrique.

11. Utilisation d'une membrane métallique nanomaillée (5) selon la revendication 9, comme revêtement pour la détection de fissures ou déchirures de surface.

## Patentansprüche

1. Verfahren zur Herstellung einer Nanogitter-Metallmembran (5), umfassend einen Schritt eines Auslegierens (1) einer dünnen Schicht (6) einer auf einem Substrat (7) abgeschiedenen Metallegierung, wobei das Verfahren **dadurch gekennzeichnet ist, dass** die dünne Schicht (6) eine Stärke zwischen 1 und 100 nm aufweist, und dass der Auslegierschritt (1) durchgeführt wird, indem die dünne Schicht (6) einem sauren Dampf (8) ausgesetzt wird, um die Nanogitter-Metallmembran (5) zu bilden.

2. Verfahren zur Herstellung nach Anspruch 1, **dadurch gekennzeichnet, dass** die Metalllegierung mindestens ein erstes Metallelement, das dazu bestimmt ist, in die Zusammensetzung der Membran (5) einzutreten, und mindestens ein zweites Metallelement, das dazu bestimmt ist, chemisch auf das Substrat (7) geätzt zu werden, umfasst, wobei das standardmäßige Redoxpotential des ersten Elements mit einer Säure höher ist als das standardmäßige Redoxpotential des zweiten metallischen Elements mit einer Säure, wobei die atomare Konzentration des zweiten metallischen Elements in dem dünnen Metallfilm (6) höher ist als ein vorbestimmter Schwellenwert, unter dem das chemische Ätzen des zweiten metallischen Elements auf dem Substrat reduziert wird.

3. Herstellungsverfahren nach einem der Ansprüche 1 und 2, **dadurch gekennzeichnet, dass** die Metalllegierung eine Vielzahl von ersten Metallelementen umfasst, die dazu bestimmt sind, in die Zusammensetzung der Nanogitter-Metallmembran (5) einzugehen.

4. Herstellungsverfahren nach einem der Ansprüche 1 bis 3, **dadurch gekennzeichnet, dass** die dünne Schicht (6) eine Stärke von weniger als 100 nm aufweist, vorzugsweise zwischen 1 und 80 nm, vorzugsweise zwischen 3 und 50 nm, vorzugsweise zwischen 5 und 20 nm liegt.

5. Herstellungsverfahren einer Nanogitter-Metallmembran (5) nach einem der Ansprüche 1 bis 4, **dadurch gekennzeichnet, dass** es einen Schritt des Ablösens (3) der Nanogitter-Membran (5) von dem Substrat (7) durch Einweichen in einer Ablöselösung (9) umfasst.

6. Herstellungsverfahren nach Anspruch 5, **dadurch gekennzeichnet, dass** es einen anschließenden Schritt des Übertragens (4) der Nanogitter-Membran (5) auf ein Objekt (10) durch Eintauchen eines Oberflächenabschnitts des Objekts (10) in die Ablöselösung (9) umfasst, was eine Perkolation der Nanogitter-Domänen bewirkt.

7. Herstellungsverfahren nach einem der Ansprüche 1 bis 6, **dadurch gekennzeichnet, dass** es einen Schritt eines Abscheidens (1) der dünnen Metallschicht (6) auf dem Substrat (7) durch Magnetronsputtern, Legierungssputtern, Aufdampfen, Co-Verdampfen, chemische Dampfabscheidung oder Laserablation umfasst.

8. Verfahren zur Herstellung nach einem der Ansprüche 6 oder 7, **dadurch gekennzeichnet, dass** die Oberfläche des Gegenstands (10) eben, liniert oder steif ist, beispielsweise die eines Zylinders, Kegels, einer Kugel oder eines Ellipsoids; oder dass die Oberfläche des Gegenstands (10) aus ebenen, nicht ebenen, linierten und/oder steifen Teilen besteht, beispielsweise die eines Fläschchens, einer Tube oder einer Flasche, insbesondere aus Glas oder Polymer.

9. Nanogitter-Metallmembran (5), die durch das Herstellungsverfahren nach einem der Ansprüche 1 bis 7 erlangt werden kann, **dadurch gekennzeichnet, dass** ihre Stärke zwischen 1 und 100 nm liegt.

10. Verwendung einer Nanogitter-Metallmembran (5) nach Anspruch 9 als transparente Beschichtung zum elektrischen Leiten.

11. Verwendung einer Nanogitter-Metallmembran (5) nach Anspruch 9 als Beschichtung zur Detektion von oberflächlichen Rissen oder Ausbrüchen.

## Claims

1. Preparation method for a nanomesh metal membrane (5) comprising a de-alloying step (1) a thin layer (6) of a metal alloy deposited on a substrate (7), said method being **characterized in that** said thin layer (6) has a thickness between 1 and 100 nm, and **in that** said de-alloying step (1) is carried out by exposing said thin layer (6) to an acid vapor (8) in order to form said nanomesh metal membrane (5).

2. Preparation method according to claim 1, **characterized in that** said metal alloy comprises at least a first metal element intended to enter the composition of said membrane (5), and at least one second metal element to be etched chemically on said substrate (7), the standard redox potential of said first element with an acid being greater than the standard redox potential of the second metal element with an acid, the atomic concentration of said second metal element in said thin metal layer (6) being greater than a predetermined threshold below which the chemical etching of said second metal element on said substrate is reduced.

3. Preparation method according to any one of claims 1 and 2, **characterized in that** said metal alloy comprises a plurality of first metal elements intended to enter into the composition of said nanomesh metal membrane (5).

4. Preparation method according to any one of claims 1 to 3, **characterized in that** said thin layer (6) has a thickness less than 100 nm, preferably between 1 and 80 nm, preferably between 3 and 50 nm, preferentially between 5 and 20 nm.

5. Preparation method for a nanomesh metal membrane (5) according to any one of claims 1 to 4, **characterized in that** it comprises a detaching step (3) of said nanomesh membrane (5) from said substrate (7) by immersion in a detaching solution (9).

6. Preparation method according to claim 5, **characterized in that** it comprises a subsequent step of transferring (4) said nanomesh membrane (5) on an object (10) by immersion of a surface portion of said object (10) in said detaching solution (9) causing the percolation of nanomesh domains.

7. Preparation method according to any one of claims 1 to 6, **characterized in that** it comprises a step of depositing (1) said thin metal layer (6) on said substrate (7) implemented by cathodic magnetron sputtering, cathodic sputtering of an alloy, evaporation, co-evaporation, chemical vapor deposition or laser ablation.

8. Preparation method according to any one of claims 6 or 7, **characterized in that** the surface of the object (10) is flat, adapted or left as is, for example this surface is that of a cylinder, a cone, sphere or ellipsoid; or the surface of the object (10) has planar, non-planar, adapted and/or left as is portions, for example this surface is that of a bottle, a tube or a bottle, in particular made of glass or polymer.

9. Nanomesh metal membrane (5) obtainable by the preparation method according to one of claims 1 to 7, **characterized in that** its thickness is between 1 and 100 nm.

10. Use of a nanomesh metal membrane (5) according to claim 9 as a transparent coating for electrical conduction.

11. Use of a nanomesh metal membrane (5) according to claim 9 as a coating for the detection of cracks or surface tears.
